# EUROPEAN PATENT SPECIFICATION

(11) **EP 0 317 879 B1**
(45) Date of publication and mention of the grant of the patent: **17.03.1993**
(21) Application number: 88119015.1
(22) Date of filing: 15.11.1988
(51) Int. Cl.: G11B 5/39, G01R 33/025, G06K 7/08

(54) **Device for detecting a magnetic medium**
Vorrichtung zum Erkennen eines magnetischen Mediums
Dispositif pour détecter un marquage magnétique

(30) Priority: 26.11.1987 SE 8704704
(43) Date of publication of application: 31.05.1989
(73) Proprietor: AB PROFOR, 221 00 Lund (SE)
(72) Inventor: Ingvert, Claes, S-223 68 Lund (SE)
(74) Representative: Müller, Hans-Jürgen, Dipl.-Ing.

(56) References cited:
- US-A- 3 969 769
- US-A- 4 142 218
- US-A- 4 283 774
- US-A- 4 603 365
- IBM Technical Disclosure Bulletin, Vol. 14, No. 8, January 1972, pages 2488-2489
- LINDER HELMUT: Taschenbuch der Elektrotechnik und Elektronik, Verlag Harri Deutsch, Thun, 1986, pages 450, 451 (ISBN 3 87 144 752 8)

## Description

The invention relates to a device for detecting a magnetic medium comprising two detector units according to the opening part of claim 1.

It is known that magnetic sensors or detector elements can be used for establishing and recording the occurrence of magnetic fields and it is also known that magnetic markings can be arranged on a carrier which are readable by magnetic sensors.Examples of such carriers and sensing arrangements are tickets for general means of transport which are provided with magnetizable coatings which may carry information concerning boarding station, fare paid etc., this information in code form being readable by sensors which can sense the occurrence of magnetic fields and arrangements by means of which the information sensed can be decoded.

The most frequently encountered and known device for detection magnetic media is probably the ordinary playback head which is present on most tape recorders. Other and more sensitive sensors for the detection of magnetic fields also exist, however, such as the so-called magneto-resistive sensors which in principle consist of an insulating core upon which is placed a thin layer of an iron-nickel alloy. If a magnetic sensor of known type is used for the detection if magnetic markings which have been applied to e.g. a packing material web in order to control the forwards feed of the web or control some other working operation, difficulties frequently occur owing to the presence of strong magnetic interference fields. On a packing machine, for example, sealings are carried out frequently with the help of induction coils which are supplied with heavy currents and which induce strong magnetic fields. Similarly, in modern machines motors and transformers are present which give rise to substantial magnetic fields. The problem which exists, therefore, is to eliminate the effect of the said interference fields when reading magnetic marks so as to obtain a reliable indication of the magnetic fields which belong to "legitimate" magnetic markings.

A device according to the opening part of claim 1 is known by US-A-4 142 218. It concerns a magnetic information tape which is a magnetic carrier and comprises different tracks of information. The object of this device is to avoid that a particular track influences the sensing of the other track of information. A respective device is also known by De-A-2 615 539. It allows to compensate magnetic interference fields.

It is an object of the present invention to enhance the effectiveness of such devices by simple means which allow to avoid the effects of different and uncertain sources of magnetic fields and to precisely sense just simple magnetic marks on a web of packing material and to keep the detector units at a constant distance from the web.

The invention is characterized in claim 1 and further embodiments are claimed in subclaims.
Fig.1 shows a schematic picture of a magnetoresistive sensor,
Fig.2 shows how four sensors are joined in a so-called Wheatstone bridge to a detector element,
Fig.3 shows how two detector elements are joined to a detector device,
Fig.4 shows how a detector device is arranged adjoining a web provided with magnetic markings,
Fig.5 shows a schematic circuit diagram which illustrates how the signal from the magnetic mark read off by the detector device is amplified and treated in accordance with the invention.

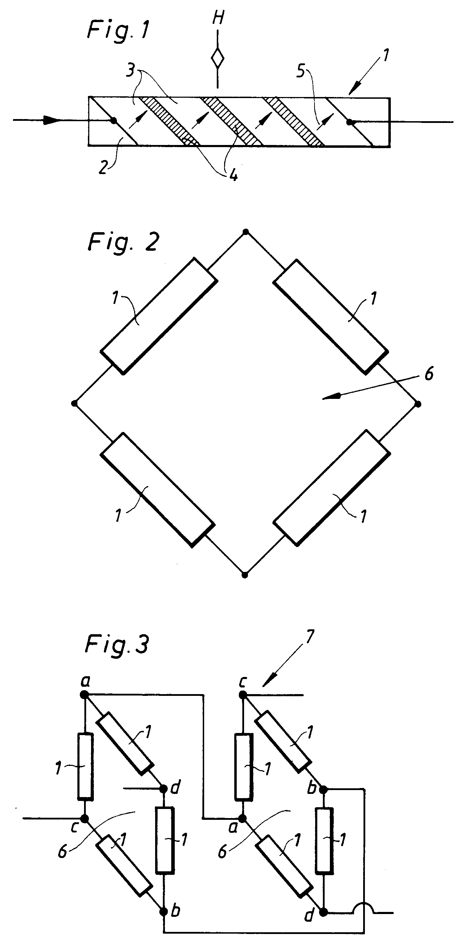

The magnetoresistive sensor 1 shown in Fig.1 consists of a core 2 of insulating material to which has been applied a thin layer 3 of an alloy, preferably an iron-nickel alloy with approx. 20% by weight of iron and 80% by weight of nickel. The electric resistance of a thin layer of a ferromagnetic alloy is a function of the direction of current in the layer and the direction of a magnetic field which may be constituted of the magnetic field caused by the current on passage through the metal layer and by the outer magnetic field. This effect is largely independent of the frequency and is sensitive also to weak magnetic fields. If the metal layer consists of an alloy of the abovementioned composition very stable properties are obtained over a certain temperature range and the change in resistance may be as great as 2-3%. Unfortunately resistance changes are not a linear function of the variation of the magnetic field if special corrections are not applied. Such a correction may consist of an "artificial outer field"but may also consist of a special arrangement which usually is called "barber-pole". The significance of this concept is shown in Fig.1 where a stripe 4 of a highly conductive metal, e.g. gold, is deposited as a spiral outside the iron-nickel layer with a winding angle of approx. 45°. The presence of this layer of highly conductive material forces the current through the low-conductive iron-nickel layer to flow in a direction of approx 45° to the longitudinal direction of the cure 2. In the Figure the direction of the current is indicated by arrows 5. Owing to the arrangement described an unknown magnetic field H which is to be determined will "twist" the resulting magnetic field against the longidutinal direction of the sensor for maximum effect of the resistance of the sensors, and this resistance can be determined easily by known methods of resistance measurement.

In order to avoid undesirable temperature sensitivity and to increase the sensitivity of the sensors, four sensors in accordance with Fig.2 can be joined together in a bridge coupling, a so-called Wheatstone bridge to form a detector element 6. If all the sensors 1 in the detector element 6 are equal, the bridge is in balance. If the bridge detector element 6 is subjected to an outer magnetic field, however, the sensors 1 which are affected most by the magnetic field (the direction of the magnetic field forms the greatest angle with the sensor 1) will be subject to a resistance change. The bridge detector element 6 will then become unbalanced and a voltage difference will arise between the corner points of the bridge when the two remaining corner points of the bridge are connected via a voltage source. This change in voltage is a measure for the strength of the magnetic field , and in order to allow a more accurate detection to take place, the voltage difference on the bridge is usually amplified in amplifiers before final indication, measurement or other signalling procedure takes place.

In order to be able to function in accordance with the invention several, preferably two, detector elements 6 have to be asssembled and joined to a detector device in the manner as shown in Figure 3. The detector device 7 which is shown in Fig.3 is built up of two detector elements 6 which in turn, in the manner mentioned earlier, are built up of four identical sensors 1 each. For the output voltage over the corner points c-d to be phase-inverted, the bridges can be joined asymmetrically as shown in the Figure. The current in both bridges or detector elements goes from a to b, if it is assumed that a is coupled to a positive potential and b is earthed. Under the influence of the outer magnetic field the bridges I,II will be unbalanced, a potent- ial difference arising between c and d. In the one detector element 6 c becomes positive in relation to d whilst the relationship in the other detector element 7 will be the reverse. In its simplest form the detector device 7 can be formed in that two detector elements 6, which are supplied commercially cast in a plastic capsule, are assembled and fixed to one another with the help of an adhesive of some kind. Naturally it is also possible to order from the manufacturer of sensors 1 and detector elements 6 a detector device 7 consisting of two bridges 6 of sensors 1 arranged at some distance from one another.

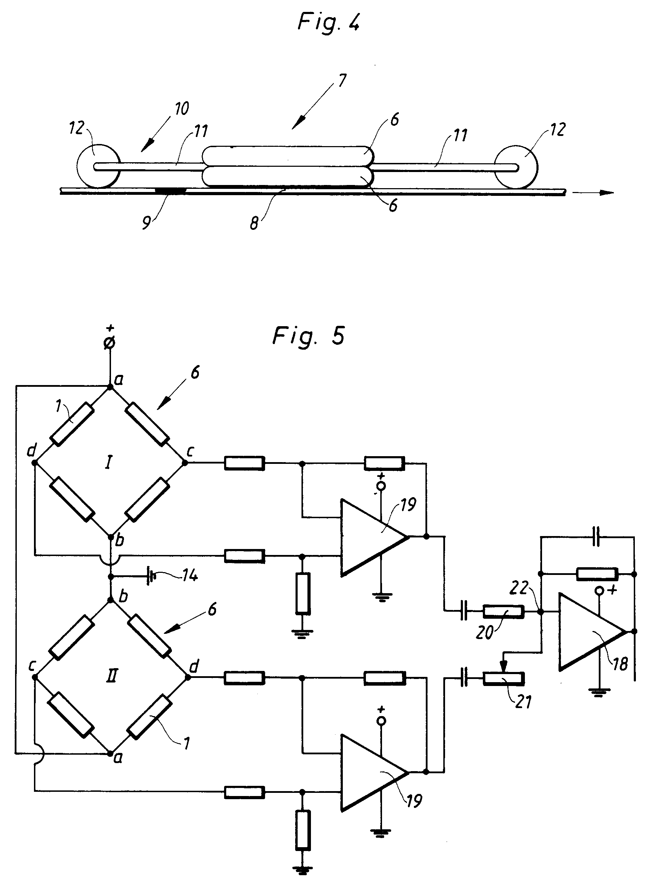

In Figure 4 is shown how a detector device 7 consisting of two detector elements arranged adjoining one another is located close to a travelling web 8 of, for example, packing material, this web 8 being a carrier of magnetic marks or markings 9. In order to maintain the detector device 7 at a constant distance from the surface of the web 8 the detector device 7 is provided with a guiding device 10 in the form of an arm 11 with a sliding shoe or roll 12. The magnetic marks 9 can have an optional function and they may be constituted, for example, of marks adapted to control and guide the forwards feed of the web in register with a printed pattern applied to the web 8 or a creaseline pattern which has been applied in order to facilitate the forming through folding of the packing material. In both cases it is important that the forwards feed should be monitored and be in register with the print and the creaseline pattern, since otherwise the printed information on the package becomes displaced and the forming occurs along folding lines other than those intended. When the web 6 is led past the detector device 7, the magnetic fields from the passing magnetic markings 9 are indicated on both the detector elements 6 included in the detector device 7. As mentioned earlier, though, the detector 7 is continuously exposed to strong magnetic interference fields emanating from motors, transformers and, in packing machines of the type referred to here, from induction sealing arrangements which comprise coils or inductors generating strong, high-frequency magnetic fields by means of which heat required for the sealing is generated along the sealing zones. The magnetic fields from the said magnetic marks 9 or markings are of a wholly different magnitude than the interference fields and are substantially weaker. In actual fact it is so that the detector device 7 has to be located quite close to the web 8 in order that the magnetic fields from the said magnetic marks 9 should be detectable. The reading of the magnetic fields of the said marks 9 thus is very "distance-dependent" owing to the magnetic field being weak, and this means that the indication of magnetic fields from a mark 9 shows great differences depending on whether the detector element adjoins the mark 9 or whether the detector element 6 is a few millimetres away from the web 8.

As is evident from Fig.4 the detector device 7 is arranged adjoining the web 8, with specially arranged guiding devices 10 consisting of an arm 11 joined to the detector device which has a sliding shoe or roll 12 adapted to slide against the web 8 continuously controlling the position of the detector device 7 in relation to the web 8. The detector device 7 is exposed the whole time to magnetic interference fields of both continuous and intermittent character. These interference fields of course are indicated by the detector elements 6 of the detector device 7, but owing to the magnitude of the interference field the deflection, or rather the output voltage from the two detector elements 6, will be of the same size. As will be explained subsequently in more detail in connection with the description of the coupling and function of the electric circuit, the output voltage from the two detector elements 6 can by coupled in phase opposition to one another. Since the voltage from the detector elements 6 generated by the magnetic interference fields are simultaneous and moreover of the same size if it is assumed that the detector elements 6 are identical, the voltages will cancel out each other when they are coupled in phase opposition (or are subtracted from one another) and this means that the resulting voltage from the detector device 7 becomes zero or, in any case, negligible.

When a magnetic mark 9 travels past the detector device 7 the two detector elements 6 included in the detector device 7 will indicate the magnetic field from the mark 9 differently owing to the detector elements 6 being located at unequal distance from the mark 9. Since the indications of the magnetic mark 9 too are simultaneous and coupled in phase opposition to one another, the indications from the two detector elements 6 will partly extinguish one another, but owing to the one detector element 6 (that located closest to the web 8) generating a stronger indication than the other detector element 6, the result will be a weakened, but distinct, pulse which constitutes an indication that a magnetic control mark 9 has been detected.

In Figure 5 is shown a schematic coupling of a circuit by means of which the signals generated by the detector elements 6 can be subtracted from one another and amplified. As is evident from Figure 5, magnetoresistive sensors 1, as mentioned previously, are joined in a bridge circuit to the detector element 6. As can be seen from Figure 5 the feed points a and earth connection points b respectively of the two bridges or detector elements 6 are arranged asymmetrically in relation to one another so that the voltage over the counterconnected "output points" c, d of the bridges 6 should lie in phase opposition to one another. This coupling in phase-opposition as such may be done in many different ways, e.g. with a so-called inverter and the example given here should be seen as only one of several possible solutions.

In Figure 5 the two detector elements 6 are also designated by I and II and, as can be seen, the connections a of the detector elements are coupled to a source of current with positive potential whereas the terminals b are connected to earth potential 14. In case of unbalance in the bridges I and II, which arises when they are influenced by an outer magnetic field, a voltage ensues over the junctions c,d of the bridges and the magnitude of this voltage difference is dependent on the magnitude of the influencing magnetic field. The junbctions c,d on each bridge or detector element 6 (I and II) are connected to so-called operational amplifiers 19 with the help of which the voltages supplied are amplified. The amplified voltages are joined at the point 22 where they at least partly extinguish one another, since they are in phase opposition. The current delivered by the operational amplifier 19 is conducted through the resistances 20 and 21, the resistance 21 being constituted of a potentiometer. With the help of the potentiometer 21 it is possible to adjust or zero the circuit, since it is difficult to get the detector elements exactly equal. In a further amplifier 18 the output signal from the arrangement can be standardized in its magnitude and in yet a further amplifier and circuits, not shown here, the output pulse can be shaped and a shape can be given to it which is such that a safe control of e.g. the forwards advance of the web is performed when pulses from a magnetic mark 9 are generated. It should be emphasized that the coupling shown here is only intended to illustrate the principle of a coupling by means of which pulses from the detector element 6 can be received and processed further, but that this coupling can be realized also in a number of different ways and that it has to be adapted to the arrangements which are intended to be controlled with the help of the pulses from the magnetic marks 9 detected.

It has been found that the arrangement in accordance with the invention functions with great operational reliability and that the influence of all interfering fields is wholly eliminated.

## Claims

1. Device for detecting a magnetic medium comprising two substantially similar detector units (6; I, II) sensitive to magnetic fields and arranged in the vicinity of but at unequal distances from said magnet medium which can be moved with respect to said detector units for creating electrical signals by said detector units each of which are electrically connected in phase opposition to an indicating unit indicating the result of said electrical signals,
**characterized in that**
each detector unit (6; I, II) comprises four substantially similar magnetic sensors (1) which are electrically connected as a Wheatstone bridge, that guiding devices (10) are fixed to said detector units (6; I, II), consisting of an arm (11) joined to said detector units (6; I, II), which arm (11) has a sliding shoe or roll (12) adapted to slide against a web of package material (8), said guiding devices (10) being suitable for maintaining said detector units (6; I, II) at a constant distance from the surface of a web (8) of packing material which is used as the carrier for the magnetic medium applied in the form of marks on said web (8).

2. Device as claimed in claim 1,
**characterized in that**
said detector units (I, II) are electrically parallel connected as regards the input connections of the Wheatstone bridges.

3. Device as claimed in claim 2,
**characterized in that**
said the input connections (a, b) of said parallelly connected detector units (I, II) are connected to different electrical poles while the output connections (c, d) thereof are connected to operational amplifiers (19) the outputs thereof are connected to resistor elements (20, 21) one of which being a potentiometer and the outputs of both of said resistor elements (20, 21) are connected to a connecting point (22) being connected to the input of a further amplifier (18).

4. Device as claimed in one of the preceedings claims,
**characterized in that**
both detector units (6) are cast in plastic capsules and fixed to one another.

## Patentansprüche

1. Vorrichtung zum Detektieren eines magnetischen Mediums, die zwei im wesentlichen gleiche Detektoreinheiten (6; I, II) aufweist, die für Magnetfelder empfindlich und in der Nähe des magnetischen Mediums, jedoch in ungleichen Abständen davon angeordnet sind, wobei das magnetische Medium in bezug auf die Detektoreinheiten bewegbar ist, um elektrische Signale von Detektoreinheiten, die jeweils gegenphasig elektrisch verbunden sind, zu einer Anzeigeeinheit erzeugen zu lassen, die das Ergebnis dieser elektrischen Signale anzeigt,
**dadurch gekennzeichnet,**
daß jede Detektoreinheit (6; I, II) vier im wesentlichen gleiche Magnetsensoren (1) aufweist, die als Wheatstone-Brücke zusammengeschaltet sind, daß Führungseinrichtungen (10) an diesen Detektoreinheiten (6; I, II) befestigt sind, die aus einem Arm (11) bestehen, der mit den Detektoreinheiten (6; I, II) verbunden ist und einen Gleitschuh oder eine Rolle (12) hat, die ausgelegt ist, um an einer Packstoffbahn (8) zu gleiten, wobei die Führungseinrichtungen (10) geeignet sind, die Detektoreinheiten (6; I, II) in einem gleichbleibenden Abstand von der Oberfläche einer Packstoffbahn (8) zu halten, die als der Träger für das magnetische Medium dient, das in Form von Markierungen auf die Bahn (8) aufgebracht ist.

2. Vorrichtung nach Anspruch 1,
**dadurch gekennzeichnet,**
daß die Detektoreinheiten (I, II) in bezug auf die Eingangsanschlüsse der Wheatstone-Brücken elektrisch parallelgeschaltet sind.

3. Vorrichtung nach Anspruch 2,
**dadurch gekennzeichnet,**
daß die Eingangsanschlüsse (a, b) der parallelgeschalteten Detektoreinheiten (I, II) an verschiedene elektrische Pole angeschlossen sind, während ihre Ausgangsanschlüsse (c, d) mit Operationsverstärkern (19) verbunden sind, deren Ausgänge mit Widerstandselementen (20, 21) verbunden sind, von denen eines ein Potentiometer ist, und die Ausgänge beider Widerstandselemente (20, 21) an einen Verbindungspunkt (22) geführt sind, der mit dem Eingang eines weiteren Verstärkers (18) verbunden ist.

4. Vorrichtung nach einem der vorhergehenden Ansprüche,
**dadurch gekennzeichnet,**
daß beide Detektoreinheiten (6) in Kunststoffgehäuse gegossen und aneinander befestigt sind.

## Revendications

1. Dispositif de détection d'un élément magnétique, comprenant deux unités de détection sensiblement identiques (6;I,II) sensibles aux champs magnétiques et placées au voisinage mais à des distances inégales dudit élément magnétique qui peut être déplacé par rapport auxdites unités de détection afin d'engendrer des signaux électriques par lesdites unités de détection qui sont chacune électriquement connectées en opposition de phase à un indicateur indiquant le résultat des dits signaux électriques,
caractérisé en ce que
chaque unité de détection (6;I, II) comprend quatre capteurs magnétiques sensiblement identiques (1) qui sont électriquement connectés en pont de Wheatstone, et des dispositifs de guidage (10) sont fixés auxdites unités de détection (6;I,II) et comprennent un bras (11) relié auxdites unités de détection (6;I,II), ce bras (11) portant un patin glissant ou un galet (12) prévu pour glisser contre une feuille de matière d'emballage (8), lesdits dispositifs de guidage (10) agissant pour maintenir lesdites unités de détection (6;I, II) à une distance constante de la surface d'une feuille (8) de matière d'emballage qui est utilisée comme support de l'élément magnétique appliqué sous la forme de marques sur ladite feuille (8).

2. Dispositif suivant la revendication 1, caractérisé en ce que
lesdites unités de détection (I,II) sont connectées électriquement en parallèle, en ce qui concerne les connexions d'entrée des ponts de Wheatstone.

3. Dispositif suivant la revendication 2, caractérisé en ce que
lesdites connexions d'entrée (a,b) desdites unités de détection connectées en parallèle (I,II) sont reliées à des pôles électriques différents, tandis que leurs connexions de sortie (c,d) sont reliées à des amplificateurs opérationnels (19) dont les sorties sont reliées à des éléments résistifs (20,21) dont l'un est un potentiomètre, et les sorties de ces deux éléments résistifs (20,21) sont reliées à un point de jonction (22) relié à l'entrée d'un autre amplificateur (18).

4. Dispositif suivant l'une quelconque des revendications précédentes,
caractérisé en ce que
les deux unités de détection (6) sont coulées dans des capsules en matière plastique et fixées l'une à l'autre.
